# EUROPÄISCHE PATENTSCHRIFT

(11) **EP 3 698 611 B1**
(45) Veröffentlichungstag und Bekanntmachung des Hinweises auf die Patenterteilung: **05.10.2022**
(21) Anmeldenummer: 18810888.0
(22) Anmeldetag: 08.11.2018
(51) Int. Cl.: H05K 7/20, G06F 1/20

(54) **LÜFTERLOSES KÜHLSYSTEM**
FANLESS COOLING SYSTEM
SYSTÈME DE REFROIDISSEMENT SANS VENTILATEUR

(30) Priorität: 07.12.2017 DE 102017222148
(43) Veröffentlichungstag der Anmeldung: 26.08.2020
(73) Patentinhaber: Siemens Mobility GmbH, 81739 München (DE)
(72) Erfinder: BIENEK, Frank, 38304 Wolfenbüttel (DE)
(86) Internationale Anmeldenummer: PCT/EP2018/080551
(87) Internationale Veröffentlichungsnummer: WO 2019/110233

(56) Entgegenhaltungen:
- DE-A1- 10 309 130
- DE-A1-102015 202 487

## Beschreibung

Die Erfindung betrifft ein lüfterloses Kühlsystem für Elektronik-Aufbausysteme zur Verwendung in Fahrzeugen, insbesondere in Schienenfahrzeugen.

Aus dem Stand der Technik ist es bekannt, dass bei einer fahrzeugseitig eingesetzten Prozessorbaugruppe (z.B. mit Intel Atom Prozessor) mit bis zu 12 Watt Verlustleistung die Verlustleistung über die Bauteiloberfläche an die Umgebung abgegeben wird oder aber über einen ausreichend dimensionierten, baugruppeninternen Kühlkörper, jeweils in Verbindung mit freier Konvektion der Luft. Als obere Grenze für den Betriebstemperaturbereich wird dabei ein Wert von 70°C definiert. Ein Lüfter ist für einen zuverlässigen Betrieb einer solchen Prozessorbaugruppe nicht erforderlich. Zur Realisierung solcher fahrzeugseitigen Rechnerplattformen kommen in der Regel Elektronik-Aufbausysteme zum Einsatz, bei denen die Prozessorbaugruppen in standardisierte Baugruppenträgern aufgenommen werden, z. B. in 19 Zoll-Baugruppenträgern.

Bei den Baugruppen handelt es sich typischerweise um quaderförmige Baugruppen, die in den rahmenförmigen Baugruppenträger einschiebbar sind, zu welchem Zweck der Baugruppenträger geeignete Führungen aufweist. Typischerweise sind die Baugruppen in Steckplätze eines Rückwandbusses steckbar und über diesen elektrisch miteinander verbunden. Die Prozessorbaugruppen sind dabei in der Regel als Steckbaugruppen ausgeführt, die in Steckplätze eines Rückwandbusses einsteckbar und über diesen elektrisch miteinander verbindbar sind. Ein Vorteil dieses Aufbausystems besteht darin, dass Baugruppen mit wenig Aufwand getauscht werden können. Hierzu müssen sie lediglich aus dem Baugruppenträger herausgezogen werden.

Für neue Rechnerplattformen für Zugsicherungseinrichtungen ist es vorgesehen, zentrale Rechner mit performanten Multicore-CPU (Mehrkernprozessoren) auszustatten, wobei die Anzahl der aktiven Kerne beispielsweise 8 oder 16 sein soll. Solche Mikroprozessoren mit mehreren vollständigen Hauptprozessorkernen in einem einzigen Chip sind im Gegensatz zu Einzelkernprozessoren sehr viel leistungsfähiger. An einen solchen zentralen Rechner werden dann weitere Funktionen (Balisenkanal, I/O-Funktionen, Odometrie-Schnittstellen) als dezentrale Geräte über ein Onboard-Kommunikationsnetzwerk angebunden.

Die Verlustleistung solcher performanten Mehrkernprozessoren (mit z.B. Intel Xeon-Prozessor) ist sehr viel höher als bei aktuellen fahrzeugseitig eingesetzten Prozessoren. Nach heutigem Stand muss dann mit einer Verlustleistung von bis zu 70 Watt ausgegangen werden. Eine ausreichende Abführung der Verlustleistung ist mit einfachen Kühlkörpern bei freier Konvektion der Luft und unter Berücksichtigung der Umweltanforderungen (EN50155, TX) nicht realisierbar. Daher werden bisher Rechnerplattformen mit Mehrkernprozessoren für Zugsicherungseinrichtungen nicht verwendet oder aber die Anwendungen nutzen nur einen einzelnen Kern eines Zwei- oder Vierkernprozessors, während die übrigen Kerne abgeschaltet sind, so dass sie keine deutlich weniger Verlustleistung produzieren.

Es ist zwar bekannt, beispielsweise Server und andere performante Rechner aktiv zu kühlen, beispielsweise mit Hilfe einer Wasserkühlung, oder aber eine aktive Klimatisierung der Einbauräume dieser Rechner vorzunehmen. Solche Maßnahmen sind jedoch für die Kühlung von Rechnern in Bahnfahrzeugen zu aufwendig und daher nicht anwendbar. Dies gilt besonders dann, wenn eine hohe Ausfallsicherheit gewährleistet werden muss, beispielsweise bei der Bereitstellung von Zugsicherungseinrichtungen.

Die Druckschrift DE 103 09 130 A1 beschreibt ein lüfterloses Kühlsystem zur Kühlung von wärmeabgebenden elektrischen und elektronischen Bauteilen insbesondere von Computerprozessoren oder Leistungselektroniken mit einem wärmeabgebenden Mehrschichtenkühlkörper, einem und/oder mehreren Wärmeröhren sowie deren Adaptersystemen zur Aufnahme der wärmeaufnehmenden und wärmeabgebenden Enden der Wärmeröhren, wobei die Adapter zur Wärmekopplung aus Kupfer und/oder deren Legierungen hergestellt sind und wobei der wärmeabgebende Mehrschichtenkühler eine ausgezeichnete Wärmeaufnahme mittels Wärmeverteilerplatte sowie eine ausgezeichnete Wärmeabgabe durch Konvektion aufweist.

Die Erfindung geht aus von einem lüfterlosen Kühlsystem für Elektronik-Aufbausysteme zur Verwendung in Fahrzeugen, insbesondere in Schienenfahrzeugen, mit einem Baugruppenträger zur Aufnahme wenigstens einer Baugruppe, insbesondere einer Prozessorbaugruppe, mit einem Wärmetransportkörper, der in wärmeübertragender Weise an ein Bauteil der Baugruppe ankoppelbar ist, wobei der Baugruppenträger wenigstens einen Wärmeverteilungskörper aufweist, an dem der Wärmetransportkörper in wärmeübertragender Weise befestigbar ist, wenn die Baugruppe, an deren Bauteil der Wärmetransportkörper angekoppelt ist, in dem Baugruppenträger aufgenommen ist, und mit wenigstens einem in wärmeübertragender Weise mit dem Wärmeverteilungskörper verbundenen Wärmerohr. Die Druckschrift DE 10 2015 202 487 A1 offenbart eine Energieumwandlungsvorrichtung, welche ein derartiges System darstellt.

Es ist eine Aufgabe der vorliegenden Erfindung, eine besonders ausfallsichere Lösung zur effizienten Kühlung für Elektronik-Aufbausysteme zur Verwendung in Fahrzeugen, insbesondere in Schienenfahrzeugen, bereitzustellen. Diese Aufgabe wird durch ein Kühlsystem nach Anspruch 1 gelöst, bei dem der Baugruppenträger zwei senkrecht stehende, in Baugruppenträger-Querrichtung verlaufende Seitenteile aufweist und bei dem die Unterseite und die Oberseite des Baugruppenträgers zumindest teilweise luftdurchlässig sind.

Das erfindungsgemäße Elektronik-Aufbausystem nach Anspruch 7 zeichnet sich durch ein solches lüfterloses Kühlsystem aus, zur Kühlung einer in dem Baugruppenträger aufgenommenen, eine Anzahl Mehrkernprozessoren aufweisenden Prozessorbaugruppe für eine fahrzeugseitige Rechnerplattform für eine Zugsicherungseinrichtung.

Mit der Erfindung wird eine lüfterlose und damit besonders ausfallsichere Lösung zur effizienten Kühlung für Elektronik-Aufbausysteme zur Verwendung in Fahrzeugen, insbesondere in Schienenfahrzeugen, bereitgestellt, die ein Entwärmen von Baugruppen mit hoher Verlustleistung, insbesondere von performanten Mehrkernprozessorbaugruppen, sicherstellt, ohne dass die Tauschbarkeit der Baugruppen eingeschränkt wird.

Vorteilhafte Ausführungen der Erfindung sind in den Unteransprüchen angegeben.

Um die Verlustleistung von performanten Mehrkernprozessoren der Baugruppe abzuleiten und entsprechend der höheren Verlustleistung auch eine vergrößerte Kühlkörperoberfläche zu realisieren, wird eine kombinierte Anwendung zweier Kühltechnologien vorgeschlagen.

Dabei soll aus Gründen der Betriebssicherheit weder auf der Baugruppe selbst ein Lüfter vorgesehen sein, noch zum Durchlüften des Baugruppenträgers insgesamt. Auch wird von dem beispielsweise aus Laptops bekannten Lösungen abgesehen, bei denen die Kühlkörper bzw. allgemein die Wärmesenke unmittelbar an der Leiterplatte bzw. der Wärmequelle, also dem auf der Leiterplatte angeordneten Bauteil, angebracht wird.

Erfindungsgemäß wird das Prinzip der Konduktionskühlung (conduction cooling) verwendet, um die Wärme von der oder den Wärmequellen abzutransportieren, hier also von der Baugruppe weg und hin zu dem Baugruppenträger, von wo aus die Wärme mit Hilfe weiterer Maßnahmen abgeführt wird. Bei diesen weiteren Maßnahmen handelt es sich vorzugsweise um die Verwendung eines Wärmerohres mit einer Vielzahl von Kühlkörpern. Von dort wird die Wärme über Konvektionskühlung aus dem Baugruppenträger und schlussendlich aus dem gesamten Aufbausystem abgeführt.

Vorteilhafterweise ist zu diesem Zweck der als Rahmen bzw. rahmenförmig ausgebildete Baugruppenträger, der typischerweise zwei Seitenteile und vier Verbindungsstege aufweist, wobei z. B. die Seitenteile mit den Verbindungsstegen an den Ecken verschraubt sind, so ausgebildet, dass die Unterseite und die Oberseite des Baugruppenträgers zumindest teilweise luftdurchlässig sind, so dass der Baugruppenträger durch Konvektion auch ohne Lüfter belüftet wird, indem ein aufsteigender Luftstrom zur Mitnahme der Wärme von den Kühlelementen und damit zur Abkühlung des Aufbausystems dient.

Die Erfindung schlägt mit anderen Worten die kombinierte Verwendung einer Konduktionskühlung mit einem Wärmerohr vor. Da Wärmerohre funktionsbedingt eine Entkopplung von Wärmeaufnahme und Wärmeabgabe erlauben, ist das erfindungsgemäße Kühlsystem nicht auf die örtliche Nähe zur Wärmequelle angewiesen. Von der wenigstens einen konduktionsgekühlten Wärmequelle innerhalb der Baugruppe kann somit über Wärmeleitung gezielt Abwärme an die großen Flächen des Baugruppenträgers bzw. der daran angebrachten Wärmerohre und von dort in den Luftstrom einer Konvektionskühlung abgegeben werden. Erfindungsgemäß dienen der Baugruppenträger bzw. der mit ihm verbundene Wärmeverteilungskörper sowie die Wärmerohre ebenso wie die gegebenenfalls an den Wärmerohren angebrachten Kühlkörper als Wärmesenke des Kühlsystems. Zusammengefasst wird also die Verlustleistung in Form von Wärme zunächst durch Konduktionskühlung von der Wärmequelle und der Baugruppe weggeleitet, um sie dann auf den Baugruppenträger bzw. auf mit dem Baugruppenträger verbundene Funktionselemente zu übertragen, wo die so zugeführte thermische Energie an ein angrenzendes Medium, hier vorzugsweise durch Konvektion geführte Luft, abgegeben wird. Anders ausgedrückt wird der Baugruppenträger selbst, der bei den bisherigen Lösungen lediglich als reines Tragelement zur mechanischen Aufnahme und Fixierung der baugruppen diente, als Wärmesenke verwendet. Dies hat den Vorteil, dass die gesamte Breite und/oder Länge bzw. Oberfläche des Baugruppenträgers zur Abgabe von Wärme an die Umgebung bzw. zur Anordnung von Kühlelementen oder dergleichen verwendet werden kann.

Dieses Entwärmungskonzept ist vorzugsweise für Prozessorbaugruppen einsetzbar, insbesondere für Baugruppen mit Mehrkernprozessoren, bei denen gegenüber Einkernprozessoren eine deutlich höhere Verlustleistung abgeführt werden muss, um die obere Grenze des Betriebs-Temperaturbereichs einhalten zu können. Trotzdem zu erwarten ist, dass sich die Anzahl der Kerne bei Mehrkernprozessoren weiter erhöht, kann davon ausgegangen werden, dass sich die abgegebene Verlustleistung verringern wird, so dass im Ergebnis das erfindungsgemäße lüfterlose Kühlsystem auch noch bei Baugruppen mit einer deutlich größeren Anzahl von Hauptprozessorkernen, beispielsweise 32 Kernen, einsetzbar ist. Die Erfindung ist jedoch auch bei anderen Arten von Baugruppen einsetzbar, insbesondere dann, wenn diese Baugruppen Bauteile mit starker Wärmeentwicklung aufweisen.

Die Erfindung ist vorzugsweise für den Einsatz in Fahrzeugen konzipiert, insbesondere zur Kühlung von performanten "on board"-Rechnerplattformen. Dabei ist die Erfindung insbesondere in Bahn- bzw. Schienenfahrzeugen einsetzbar. Die Erfindung ist jedoch auch einsetzbar in anderen Arten von Fahrzeugen, wie beispielsweise Wasserfahrzeugen und Luftfahrzeugen, wo ähnliche Anforderungen die Ausfallsicherheit gestellt werden und daher nur lüfterlose Systeme zum Einsatz kommen können.

Die Erfindung ist besonders vorteilhaft zur ausfallsicheren Kühlung von Rechnerplattformen für fahrzeugseitige Zugsicherungseinrichtungen geeignet. Aufgrund der Erfindung kann eine dauerhafte Kühlung der Prozessorbaugruppe(n) und damit die Betriebsbereitschaft der entsprechenden Rechnerplattform sichergestellt werden. Dies ist bei Zugsicherungseinrichtungen besonders wichtig, weil die dort bereitzustellenden Funktionen einem hohen Sicherheitsstandard genügen sowie ein hohes Maß an Zuverlässigkeit aufweisen müssen. Der Ausfall einer Zugsicherungsfunktion kann zum Ausfall des gesamten Fahrzeugs führen. Besonders vorteilhaft ist es, dass bereits vorhandenen Baugruppenträger nachträglich mit den Komponenten des erfindungsgemäßen Kühlsystems ausgerüstet werden können. So können eine Anzahl geeigneter Wärmeverteilungskörper und die benötigten Wärmerohre an dem Baugruppenträger nachträglich angebracht werden. Ebenso können die in diesem Baugruppenträger zum Einsatz kommenden Baugruppen mit einem geeigneten Wärmetransportkörper nachgerüstet werden. Damit sind alle Komponenten des Kühlsystems auch nachträglich hinzufügbar und Baugruppenträger, die sich bereits im Einsatz befinden, können Prozessorbaugruppen mit Mehrkernprozessoren aufnehmen, ohne dass es zu Problemen mit der Abfuhr der Verlustleistung kommt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Dabei zeigen:
FIG 1 eine Seitenansicht einer ersten Ausführungsform eines Kühlsystems,

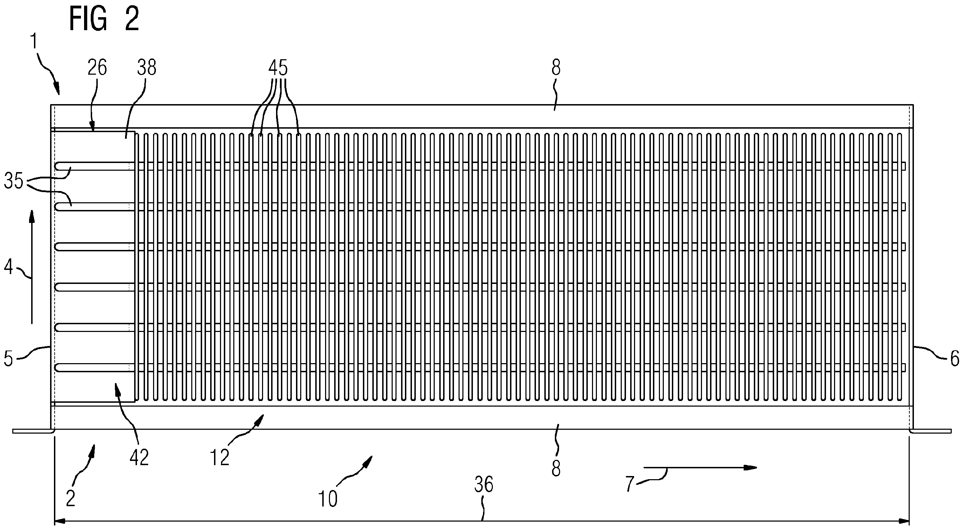

FIG 2 eine Draufsicht auf das Kühlsystem aus FIG 1,
FIG 3 eine Seitenansicht einer zweiten Ausführungsform eines Kühlsystems.

Sämtliche Figuren zeigen die Erfindung lediglich schematisch und mit ihren wesentlichen Bestandteilen. Gleiche Bezugszeichen entsprechen dabei Elementen gleicher oder vergleichbarer Funktion.

Zur Realisierung eines Elektronik-Aufbausystems 1 für eine fahrzeugseitige Rechnerplattform für eine Zugsicherungseinrichtung dient ein rahmenförmiger 19-Zoll-Baugruppenträger 2, der eine oder mehrere Prozessorbaugruppen 3 sowie optional weitere Baugruppen, beispielsweise Kommunikationsbaugruppen, aufnehmen kann. Der Baugruppenträger 2 weist erfindungsgemäß zwei zu einer Unterseite (11) und einer Oberseite (12) des Baugruppenträgers (2) senkrecht stehende, in Baugruppenträger-Querrichtung 4 verlaufende Seitenteile 5, 6 und vier in Baugruppenträger-Längsrichtung 7 verlaufende Verbindungsstege 8, 9 auf, wobei die Seitenteile 5, 6 mit den Verbindungsstegen 8, 9 an den Ecken verschraubt oder auf andere Weise verbunden sind. Außerdem ist der Baugruppenträger 2 so ausgebildet, dass die Unterseite 11 und die Oberseite 12 des Baugruppenträgers 2 zumindest teilweise luftdurchlässig sind. Dadurch wird eine freie Konvektion, also eine Luftströmung 13 von unten nach oben durch das Innenvolumen 14 des Baugruppenträgers 2 hindurch ermöglicht. Der Baugruppenträger 2 ist zur Abfuhr der Wärme besonders gut geeignet, da er über eine vergleichsweise große Oberfläche verfügt. Dabei können die Konstruktionselemente des Baugruppenträges 2 selbst als Wärmeweiterleitungs- bzw. Kühlkörper verwendet werden.

Die Prozessorbaugruppe 3 weist einen Mehrkernprozessor 15 mit sechzehn Hauptprozessorkernen sowie ein weiteres, Verlustleistung abgebendes elektrisches Bauteil 16 auf, das auf einer Leiterplatte 17 der Baugruppe 3 angebracht und dort kontaktiert ist. Dabei kann jede Baugruppe 3 eine oder mehrere Leiterplatten 17 aufweisen. Diese Mehrkernprozessoren 15 oder weiteren Bauteile 16 der Baugruppe 3 wirken als Wärmequellen.

Als Bestandteil der Baugruppe 3 ist ein Wärmetransportkörper 18 vorgesehen, der in wärmeübertragender Weise an diejenigen Bauteile 15, 16 der Baugruppe 3 ankoppelbar ist, von denen die Verlustleistung in Form von Wärme abgeführt werden soll.

Die Kühlung, genauer gesagt der Abtransport der Verlustleistung in Form von Wärme, erfolgt somit zunächst durch Wärmeleitung. Zu diesem Zweck ist der aus einem wärmeleitfähigen Material, vorzugsweise aus Aluminium, hergestellte Wärmetransportkörper 18 an der Wärmequelle, also an das zu kühlende Bauteil 15, 16 thermisch angekoppelt und die Wärme wird durch physischen Kontakt abgeführt. Der Wärmetransportkörper 18 ist vorzugsweise als Rahmen, Block, Schale oder Wanne ausgeführt und individuell an die Anordnung der Bauteile (Wärmequellen) 15, 16 auf der Leiterplatte 17 angepasst. Er dient außerdem als Gehäuse, das die Leiterplatte 17 bzw. die Baugruppe 3 zumindest teilweise umhüllt. Der Wärmetransportkörper 18 dient zugleich zum Schutz vor Beschädigungen der Leiterplatte 17 und der damit verbundenen Bauteile 15, 16 und/oder zum Schutz weiterer Komponenten (nicht dargestellt) der Baugruppe 3.

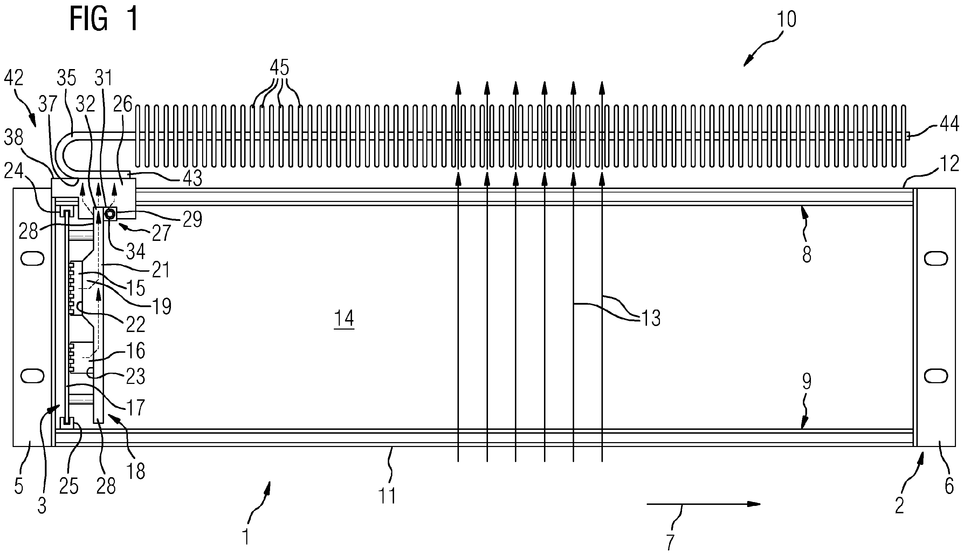

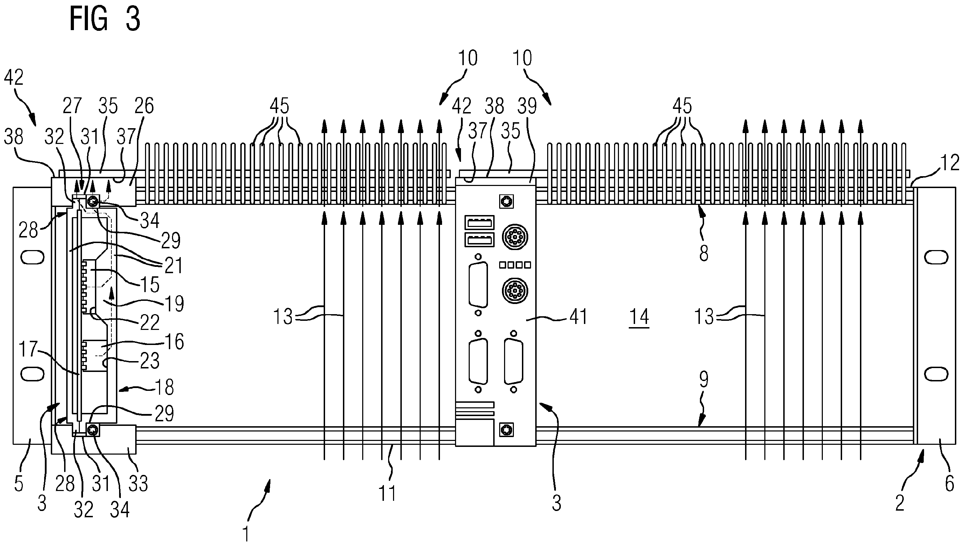

Während der Wärmetransportkörper 18 in dem in FIG 1 gezeigten Ausführungsbeispiel lediglich auf einer Seite der Leiterplatte 17 angeordnet ist, ist in dem in FIG 3 gezeigten Ausführungsbeispiel die Leiterplatte 17 beidseitig von dem Wärmetransportkörper 18 umgeben, der zu diesem Zweck aus zwei Aluminiumschalen besteht, die ein Gehäuse bilden, in das die Leiterplatte 17 quasi eingebettet ist. Dabei liegen Kontaktierungskörper 19, wie beispielsweise gefräste Dome, die sich im montierten Zustand aus dem plattenförmigen Grundkörper 21 des Wärmetransportkörpers 18 in Baugruppenträger-Längsrichtung 7 heraus erstrecken und an denen Kontaktflächen 22 ausgebildet sind, an den Wärmequellen ("hot spots") 15 der Baugruppe 3 an bzw. der Grundkörper 21 selbst liegt mit einer Kontaktfläche 23 an einer solchen Wärmequelle 16 an. Zur Wärmeübertragung von den auf der Leiterplatte 17 angeordneten Bauteilen 15, 16 auf den Wärmetransportkörper 18 kann auf den Kontaktflächen 22, 23 ein geeignetes Wärmeübertragungsmittel, beispielsweise eine Wärmeübertragungspaste, aufgetragen sein.

Im montierten Zustand steht die Leiterplatte 17 der Baugruppe 3 und zugleich auch der plattenförmige Grundkörper 21 des Wärmetransportkörpers 18 senkrecht und parallel zu den Seitenteilen 5, 6 zwischen den oberen und unteren Verbindungsstegen 8, 9 des Baugruppenträgers 2. Die Leiterplatte 17 ist zur mechanischen Sicherung ihrer Lage in dafür vorgesehene Führungen 24 des Baugruppenträgers 2 einschiebbar. Diese Führungen 24, 25 sind bedarfsweise an den oberen und unteren Verbindungsstegen 8, 9 angebracht. Im montierten Zustand ist daher die in ihrer Einbaulage senkrecht stehende Leiterplatte 17 sowohl in einer oberen Führung 24 als auch in einer unteren Führung 25 des Baugruppenträgers 2 eingeschoben.

Gleichzeitig kann der Wärmetransportkörper 18 der Baugruppe 3 in wärmeübertragender Weise lösbar an wenigstens einem Wärmeverteilungskörper 26 des Baugruppenträgers 2 befestigt werden, um eine ausreichende Wärmeleitung von der Baugruppe 3 zu dem Baugruppenträger 2 zu ermöglichen. Vorzugsweise dient dabei eine Keilschlossvorrichtung 27 zum Befestigen des Wärmetransportkörpers 18 an dem Wärmeverteilungskörper 26 in wärmeübertragender Weise. Anstelle einer Keilschlossvorrichtung 27 kann eine andere formschlüssige Verbindung verwendet werden, um die Verlustleistung auf den Wärmeverteilungskörper 26 zu übertragen. Die Tauschbarkeit der Baugruppen 3 bleibt dabei nach wie vor möglich, indem die formschlüssige Verbindung gelöst wird.

Der Wärmetransportkörper 18, der einerseits mit seinen Kontaktflächen 22, 23 an dem konduktionsgekühlten Mehrkernprozessor 15 bzw. einem weiteren konduktionsgekühlten Bauteil 16 anliegt, ist andererseits an seinen im montierten Zustand nach oben und unten weisenden Verbindungsenden 28 plattenförmig ausgeformt, so dass er in dem Wärmeverteilungskörper 26 des Baugruppenträgers 2 mit der Keilschlossvorrichtung 27 gesichert werden kann. Der Wärmeverteilungskörper 26, der an den oberen Verbindungsstegen 8 befestigt sowie in unmittelbarer Nachbarschaft zu der oberen Führung 24 des Baugruppenträgers 2 platziert ist, weist zu diesem Zweck wenigstens eine Führungsanordnung auf, die aus parallelen Kopplungsgliedern bestehen, zwischen denen sich ein Einschubschlitz 31 für eine montageseitige Plattenkante 32 des Grundkörpers 21 des Wärmetransportkörpers 18 ergibt.

Während in den einen Ausführungsformen der Erfindung ein oder mehrere Wärmeverteilungskörper 26 nur oberhalb der Baugruppe 3 vorgesehen sind (FIG 1), können in anderen Ausführungsformen Wärmeverteilungskörper 26 auch unterhalb der Baugruppe 3 vorgesehen sein, insbesondere bei als Gehäuse ausgeführten und damit schweren Wärmeverteilungskörpern 33, welche die Leiterplatte 17 beidseitig umhüllen und damit quasi einbetten (FIG 3). Diese untenliegenden Wärmeverteilungskörper 33 dienen in diesen Fällen in erster Linie zur mechanischen Befestigung der Baugruppe 3 in dem Baugruppenträger 2, vorzugsweise auf die gleiche Weise wie bei dem obenliegenden Wärmeverteilungskörper 26; eine wesentliche Wärmeübertragung von der Baugruppe 3 an die Unterseite 11 des Baugruppenträgers 2 zum Zweck der Entwärmung der Baugruppe 3 ist hingegen nicht beabsichtigt. Ist die

Leiterplatte 17 in den Wärmetransportkörper 18 eingebettet, wie in FIG 3 illustriert, werden separate Führungen 24, 25 für die Leiterplatte 17 nicht zwingend benötigt. Stattdessen kann die Leiterplatte 17 in dem Wärmetransportkörper 18 befestigt sein, beispielsweise zwischen den beiden das Gehäuse bildenden Halbschalen.

Aufbau und Funktionsweise der Keilschlossvorrichtung 27 werden nachfolgend beschrieben, ohne dass die Komponenten der Keilschlossvorrichtung 27 in den Figuren im Detail dargestellt sind. Die Keilschlossvorrichtung umfasst typischerweise einen Mittelkeil, der geneigte Oberflächen an seinen beiden gegenüberliegenden Enden aufweist, und zwei Endkeile, die jeweils eine geneigte Oberfläche aufweisen, die an den geneigten Oberflächen des Mittelkeils anliegen. In den Figuren ist dabei lediglich die äußere Kopffläche des vorderen Endkeils 29 abgebildet. Der Mittelkeil ist dabei so ausgebildet, dass er an der Plattenkante 32 des Wärmetransportkörpers 18 befestigt werden kann. Eine Spindel erstreckt sich in Längsrichtung, hier der Baugruppenträger-Querrichtung 4 entsprechend, durch den Mittelkeil und verbindet diesen mit den beiden Endkeilen. Der von dem Schraubkopf 34 abgewandte Endkeil besitzt eine Gewindebohrung, in die Spindel derart eingreift, dass eine Drehung der Spindel im Uhrzeigersinn die beiden Endkeile aufeinander zieht. Da die geneigten Oberflächen der beiden Endkeile gegen die geneigten Oberflächen des Mittelkeils anliegen, werden die Endkeile durch das Drehen der Spindel veranlasst, sich quer nach außen zu spreizen. Hierdurch wird die wirksame Breite des Keilschlosses auf die Breite des Einschubschlitzes 31 vergrößert, so dass das Keilschloss selbst eine Fixierung in dem Einschubschlitz 31 bewirkt. Eine weitere Drehung der Spindel im Uhrzeigersinn spannt die Vorrichtung weiter an. Ein Lösen des Keilschlosses ist möglich, indem die Spindel in Gegenrichtung gedreht wird, wodurch die beiden Enden der Keile in Längsrichtung auseinanderlaufen und die wirksame Breite des Keilschlossaufbaus vermindert wird, so dass die Klemmkraft des Keilschlossaufbaus innerhalb des Einschubschlitzes 31 soweit verringert wird, dass die Plattenkante 32 des Wärmetransportkörpers 18 aus dem Einschubschlitz 31 entfernt werden kann.

Während also die Baugruppe 3, genauer gesagt die Leiterplatte 17, in entsprechende Führungen 24, 25 des Baugruppenträgers 2 eingeschoben wird, wobei über diese mechanische Verbindung keine Wärme oder nur ein unwesentlicher Betrag der innerhalb der Baugruppe 3 entstandenen Wärme übertragen wird, überträgt der Wärmetransportkörper 18, der die Wärme über seine Kontaktflächen 22, 23 aufgenommen hat, diese Wärme vorzugsweise über spezielle Keilschlösser bzw. Spannkeile (wedge locks), die ebenfalls aus einem thermisch leitfähigen Material bestehen, direkt an den Baugruppenträger 2, genauer gesagt an den an dem Baugruppenträger 2 angebrachten Wärmeverteilungskörper 26, der vorzugsweise als massiver Materialblock ausgeführt ist. Der Wärmeverteilungskörper 26 ist dabei ebenfalls aus Aluminium gefertigt oder besteht aus einem anderen geeigneten Material. Anschließend wird die Wärme von dem Wärmeverteilungskörper 26 an eines oder mehrere Wärmerohre 35 abgegeben, die einen hohen Wärmeleitwert haben und sich vorzugsweise im Wesentlichen über die gesamte Länge bzw. Breite des Baugruppenträgers 2 erstrecken.

Zu diesem Zweck sind an dem wenigstens einen Wärmeverteilungskörper 26 in gleichmäßigen Abständen mehrere baugleiche Wärmerohre 35 in Form von Heatpipes angebracht, die dazu dienen, die Wärme über die gesamte Baubreite 36 des Baugruppenträgers 2 zu verteilen, von wo aus die Wärme durch Konvektionskühlung nach außen bzw. von dem Baugruppenträger 2 weg geführt werden kann. Die Wärmerohre 35 sind mit ihren Kontaktflächen 37 an den Wärmeverteilungskörper 26 angekoppelt. Der Wärmeverteilungskörper 26 ist in Bezug auf den Baugruppenträger 2 vorzugsweise obenliegend angeordnet und zu diesem Zweck an den oberen Verbindungsstegen 8 angebracht derart, dass seine Wärmeverteilungskörperaußenseite 38 an der Oberseite 12 des Baugruppenträgers 2 liegt bzw. aus der Oberseite 12 herausragt derart, dass die daran angekoppelten Wärmerohre 35 ebenfalls an der Oberseite 12 des Baugruppenträgers 2 entlang verlaufen, genauer gesagt in einem definierten Abstand von dieser Oberseite 12. Vorzugsweise sind die Wärmerohre 35 dabei außerhalb des von dem Rahmen 5, 6, 8, 9 des Baugruppenträgers 2 definierten Innenvolumens 14 angeordnet. In jedem Fall verlaufen die Wärmerohre 35 aus Sicht der Konvektionskühlung stets oberhalb der zu kühlenden Baugruppen 3, so dass eine Selbsterwärmung der Baugruppen 3 durch von den Wärmerohren 35 abgegebene Wärme vermieden wird. Vorzugsweise erstrecken sich die Wärmerohre 35 in Baugruppenträger-Querrichtung 4. Im illustrierten Beispiel sind sechs mit dem Wärmeverteilungskörper 26 verbundene Wärmerohre 35 parallel zueinander liegend angeordnet.

Das erfindungsgemäße Entwärmungskonzept kann nicht nur bei Baugruppenträgern 2 verwendet werden, die eine einzige Baugruppe 3 mit Bauteilen 15, 16 aufweist, die auf diese Weise gekühlt werden sollen. Das Konzept ist auch übertragbar auf Baugruppenträger 2, in denen zwei, drei oder mehr dieser Baugruppen 3 aufgenommen sind. Dabei muss die Anordnung der Wärmeverteilungskörper 26 sowie der damit verbundenen Wärmerohre 35 an die Platzierung der Baugruppen 3 in dem Baugruppenträger 2 angepasst werden oder umgekehrt.

Vorzugsweise ist der Wärmeverteilungskörper 26 nahe des einen Seitenteils 5 des Baugruppenträgers 2 montiert, so dass sich ein von dem Wärmeverteilungskörper 26 ausgehendes Wärmerohr 35 über eine möglichst große Weglänge über die gesamte Breite 36 des Baugruppenträgers 2 bis hin zu dem gegenüberliegenden Seitenteil 6 erstrecken kann. Ist nur eine einzige Prozessorbaugruppe 3 vorhanden, bleibt es bei dem so positionierten Wärmeverteilungskörper 26 (FIG 1). Sind zwei Prozessorbaugruppen 3 in dem Baugruppenträger 2 aufgenommen (FIG 3), so gilt dies für den ersten Wärmeverteilungskörper 26 ebenso, jedoch ist zusätzlich ein zweiter, oben angeordneter Wärmeverteilungskörper 39 mittig zwischen den beiden Seitenteilen 5, 6 des Baugruppenträgers 2 vorgesehen und von jedem der beiden Wärmeverteilungskörper 26, 39 erstrecken sich die Wärmerohre 35 über jeweils etwa die halbe Breite 36 des Baugruppenträgers 2, dabei erneut die zur Verfügung stehende Oberfläche des Baugruppenträgers 2 möglichst vollständig ausnutzend. In FIG 3 ist die mittig angeordnete Baugruppe 3 mit ihrer Frontplatte 41 dargestellt.

Die Wärmerohre 35 können dabei, wie in FIG 1 dargestellt, in einem definierten Abstand zu der Oberseite 12 des Baugruppenträgers 2 verlaufen. In diesem Fall sind die Wärmerohre 35 an ihrer Verbindungsseite 42 hin zu dem Wärmeverteilungskörper 26 U-förmig gebogen ausgeführt, wobei der untere U-Schenkel 43 mit der Kontaktfläche 37 auf der Außenseite 38 des Wärmeverteilungskörpers 26 aufliegt, während sich der obere U-Schenkel 44, der in einer vertikalen Ebene mit dem unteren U-Schenkel 43 liegt, von dem Wärmeverteilungskörper 26 weg in Richtung des gegenüberliegenden Seitenteils 6 des Baugruppenträgers 2 erstreckt.

Die Wärmerohre 35 können aber auch, wie in FIG 3 dargestellt, als gerade Rohre mit wenig Abstand zum Baugruppenträger 2 und damit platzsparend angeordnet sein. Sie sind dann an ihren Verbindungsseiten 42 mit ihren Kontaktflächen 37 mit den Außenseiten 38 der Wärmeverteilungskörper 26, 39 thermisch verbunden.

Die Ankopplung des Wärmetransportkörpers 18 an die Wärmequellen 15, 16 und/oder die Ankopplung des Wärmetransportkörpers 18 an den oder die Wärmeverteilungskörper 26, 39 des Baugruppenträgers 2 und/oder die Ankopplung der Wärmerohre 35 an den oder die Wärmeverteilungskörper 26, 39 erfolgt in wärmeübertragender Weise über geeignete Wärmekontaktflächen, bei denen es sich vorzugsweise um ebene Flächen handelt, so dass jeweils ein Formschluss hergestellt werden kann. Die entsprechenden Wärmekontaktflächen sind zur Übertragung großer Wärmeströme vorzugsweise möglichst groß ausgebildet.

Die Funktionsweise eines Wärmerohres 35 als Wärmeübertrager, der unter Nutzung von Verdampfungswärme eines Mediums einen Transport großer Wärmemengen erlaubt, ist dem Fachmann grundsätzlich bekannt. Vorzugsweise kommt hier eine sogenannte Heatpipe zum Einsatz, typischerweise in Form eines rohrförmigen Volumens, in welchem sich das Arbeitsmedium des Wärmerohres 35 befindet. Das bei Wärmeeintrag in der Heizzone des Wärmerohres 35, also im Bereich der Ankopplung des Wärmerohres 35 an den Wärmeverteilungskörper 26, 39, verdampfende Arbeitsmedium strömt zu der Kühlzone des Wärmerohres 35, wo es kondensiert und die freiwerdende Kondensationswärme an die Umgebung abgegeben werden kann. Das nun flüssige Arbeitsmedium kehrt durch Kapillarkräfte wieder zurück zu der Stelle, an der die Wärme eingeleitet wird. Der Einsatz von Heatpipes ist vorteilhaft, da der Prozess der Rückführung des Arbeitsmediums zu dem Verdampfer lageunabhängig ist, im Gegensatz zu solchen Wärmerohren 35, die nach dem Prinzip des Thermosiphons arbeiten, bei denen das flüssige Arbeitsmedium durch Schwerkraft zurückgeführt wird. Die hier eingesetzten Heatpipes können somit, wie dargestellt, waagerecht an dem Baugruppenträger 2 angebracht sein, ohne dass ein Austrocknen zu befürchten ist, weil das kondensierte Arbeitsmedium aufgrund einer zu flachen Neigung nicht schnell genug zurückfließt.

Die Wärmerohre 35 sind an ihren Oberflächen mit einer Vielzahl von Kühlkörpern 45 versehen, die vorzugsweise als Kühlrippen ausgeführt sind. Da sich die Wärmerohre 35 vorzugsweise über die gesamte Breite 36 des Baugruppenträgers 2 erstrecken, ist vorzugsweise im Wesentlichen die gesamte Oberseite 12 des Baugruppenträgers 2 mit Kühlkörpern 45 versehen, so dass eine sehr große Kühlfläche gebildet wird. Hierdurch kann auch die bei Mehrkernprozessoren deutlich erhöhte Verlustleistung durch einfache freie Konvektion der Luft entlang der Kühlkörper 45 an die Umgebung abgegeben werden. Die Abgabe der Verlustleistung an die umgebende Luft erfolgt somit lüfterlos.

Die verwendeten Kühlkörper 45 sind vorzugsweise plattenförmig ausgeführt, wobei die Platten vertikal ausgerichtet sind, so dass sie den Abtransport der Wärme mittels Konvektionskühlung unterstützen, wobei die Luftströmung 13 entlang der großflächigen Längsseiten der Kühlkörperplatten von unten nach oben durch diese hindurch verläuft. Dabei sind vorzugsweise nicht für jedes Wärmerohr 35 eigene Kühlkörper 45 vorgesehen. Stattdessen sind die in Baugruppenträger-Querrichtung 4 verlaufenden, parallel zueinander angeordneten Kühlkörper 45 jeweils mit allen sechs Wärmerohren 35 verbunden, so dass sich eine besonders gleichmäßige Verteilung der Wärmeabgabe an die durchströmende Luft ergibt.

Je nach Platzierung der Wärmerohre 35 sind die Kühlkörper 45 oberhalb des Innenvolumens 14 des Baugruppenträgers 2 angeordnet (FIG 1) oder aber ragen wenigstens teilweise in dieses Innenvolumen 14 hinein (FIG 3).

Typ- und Formauswahl sowie Anordnung der Kühlkörper 45 erfolgen mit dem Ziel, eine möglichst große Kühlkörperfläche bereitzustellen, insbesondere die Anzahl der Kühlkörper 45 über die Fläche des Baugruppenträgers 2 zu maximieren. Die Wärmerohre 35 ermöglichen es dabei, die über die Kühlkörper 45 abzugebende Wärme bis an den von dem Wärmeverteilungskörper 26, 39 am weitesten entfernten Punkt des Baugruppenträgers 2 zu transportieren, um die größtmögliche Fläche des Baugruppenträgers 2 zum Zweck der Wärmeabfuhr zu nutzen. Erfindungsgemäß wird somit die Verlustleitung von Form von Wärme von der Baugruppe 3 weggeführt; die Wärme wird dabei jedoch nicht zu einer von dem Baugruppenträger entfernten Wärmesenke transportiert, um die Wärme abzugeben. Statt dessen ist die Wärmesenke als Teil des Baugruppenträgers 2 und damit in unmittelbarer Nähe zu dem Innenvolumen 14 des Baugruppenträgers 2 verwirklicht, hier in Form der Wärmerohre 35 mit Kühlkörpern 45, so dass die Abfuhr der abgegebenen Wärme, genauer gesagt der Abtransport der Wärme von dem Baugruppenträger 2 weg, durch die durch das Innenvolumen 14 des Baugruppenträgers 2 hindurch laufende Luftströmung erfolgen kann.

Alternativ zu einer Vielzahl einzelner (kleiner) Kühlkörper ist es ebenfalls möglich, einen einzelnen, mit Durchbrüchen oder Öffnungen zum Durchtritt der Konvektionsströmung versehenen (großen) Kühlkörper mit einer Vielzahl von Kühlflächen zur Anbringung an den Wärmerohren 35 zu verwenden, oder mehrere solcher (großen) Kühlkörper.

Da weiterhin Standard 19"-Baugruppenträger-Technik das Aufbausystem 1 bildet, können neben Baugruppen, deren Entwärmung mit Hilfe des erfindungsgemäßen Entwärmungskonzeptes erfolgt, auch Baugruppen mit wenig Verlustleistung (nicht dargestellt) konventionell bestückt werden. Diese Baugruppen, z.B. Peripherie-Baugruppen für digitalen Input/Output, Daten-Schnittstellen usw., geben somit weiterhin die Wärme über die Bauteiloberfläche ab und können in gewohnter Weise in den Baugruppenträger 2 integriert werden. Es ist mit anderen Worten auch weiterhin möglich, in dem für die erfindungsgemäße Kühlung ertüchtigten Baugruppenträger 2 in konventioneller Weise Baugruppen mit wenig Verlustleistung einzubauen, ohne das erfindungsgemäße Entwärmungskonzept nutzen zu müssen. Das mit der Erfindung vorgeschlagene lüfterlose Kühlsystem 10 mit Wärmetransportkörper 18, Wärmeverteilungskörper 26, 39 und Wärmerohren 35 hindert also nicht die Verwendung des Baugruppenträgers mit einer traditionellen Baugruppenbestückung, ohne dass das spezielle Entwärmungskonzept angewendet wird. Baugruppenträger 2, die wie oben beschrieben, im Sinne des erfindungsgemäßen Entwärmungskonzeptes ertüchtigt wurde, sind daher besonders universell einsetzbar.

In den Figuren nicht dargestellt sind der besseren Übersicht halber die Befestigungskonstruktionen für die Wärmerohre 35 und die daran angebrachten Kühlkörper 45, sowie mögliche Peripheriebaugruppen, weitere Führungsschienen und Baugruppenträger-Anteile.

Obwohl die Erfindung im Detail durch das bevorzugte Ausführungsbeispiel näher illustriert und beschrieben wurde, so ist die Erfindung nicht auf die offenbarten Beispiele eingeschränkt und andere Variationen können vom Fachmann hieraus abgeleitet werden, ohne den Schutzumfang der Erfindung gemäß den angehängten Ansprüchen zu verlassen.

### Bezugszeichenliste

- 1: Elektronik-Aufbausystem
- 2: Baugruppenträger
- 3: Baugruppe, Mehrprozessorbaugruppe
- 4: Baugruppenträger-Querrichtung
- 5: Baugruppenträger-Seitenteil
- 6: Baugruppenträger-Seitenteil
- 7: Baugruppenträger-Längsrichtung
- 8: oberer Baugruppenträger-Verbindungssteg
- 9: unterer Baugruppenträger-Verbindungssteg
- 10: Kühlsystem
- 11: Baugruppenträger-Unterseite
- 12: Baugruppenträger-Oberseite
- 13: Luftströmung
- 14: Innenvolumen des Baugruppenträgers
- 15: Prozessor, Wärmequelle
- 16: elektrisches/elektronisches Bauteil, Wärmequelle
- 17: Leiterplatte
- 18: Wärmetransportkörper
- 19: Kontaktierungskörper
- 20: (frei)
- 21: Grundkörper des Wärmetransportkörpers
- 22: erste Kontaktfläche des Wärmetransportkörpers
- 23: zweite Kontaktfläche des Wärmetransportkörpers
- 24: obere Führung
- 25: untere Führung
- 26: oberer Wärmeverteilungskörper
- 27: Keilschlossvorrichtung
- 28: Verbindungsende
- 29: Endkeil
- 30: (frei)
- 31: Einschubschlitz
- 32: Plattenkante
- 33: unterer Wärmeverteilungskörper
- 34: Schraubkopf
- 35: Wärmerohr, Heatpipe
- 36: Baubreite des Baugruppenträgers
- 37: Kontaktfläche
- 38: Außenseite des Wärmeverteilungskörpers
- 39: oberer Wärmeverteilungskörper
- 40: (frei)

- 41: Frontplatte
- 42: Verbindungsseite
- 43: unterer U-Schenkel
- 44: oberer U-Schenkel
- 45: Kühlkörper

## Patentansprüche

1. Lüfterloses Kühlsystem (10) für Elektronik-Aufbausysteme (1) zur Verwendung in Fahrzeugen, insbesondere in Schienenfahrzeugen,
- mit einem Baugruppenträger (2) zur Aufnahme wenigstens einer Baugruppe (3), insbesondere einer Prozessorbaugruppe,
- mit einem Wärmetransportkörper (18), der in wärmeübertragender Weise an ein Bauteil (15, 16) der Baugruppe (3) ankoppelbar ist,
- wobei der Baugruppenträger (2) wenigstens einen Wärmeverteilungskörper (26; 39) aufweist, an dem der Wärmetransportkörper (18) in wärmeübertragender Weise befestigbar ist, wenn die Baugruppe (3), an deren Bauteil (15, 16) der Wärmetransportkörper (18) angekoppelt ist, in dem Baugruppenträger (2) aufgenommen ist,
- und mit wenigstens einem in wärmeübertragender Weise mit dem Wärmeverteilungskörper (26; 39) verbundenen Wärmerohr (35)
**dadurch gekennzeichnet,**
**dass** der Baugruppenträger (2) zwei zu einer Unterseite (11) und einer Oberseite (12) des Baugruppenträgers (2) senkrecht stehende, in Baugruppenträger-Querrichtung (4) verlaufende Seitenteile (5, 6) aufweist und
**dass** die Unterseite (11) und die Oberseite (12) des Baugruppenträgers (2) zumindest teilweise luftdurchlässig sind.

2. Kühlsystem (10) nach Anspruch 1, wobei der Wärmetransportkörper (18) als ein eine Leiterplatte (17) der Baugruppe (3) zumindest teilweise umhüllendes Gehäuse ausgeführt ist.

3. Kühlsystem (10) nach Anspruch 1 oder 2, mit einer Keilschlossvorrichtung (27) zum Befestigen des Wärmetransportkörpers (18) an dem Wärmeverteilungskörper (26; 39) in wärmeübertragender Weise.

4. Kühlsystem (10) nach einem der Ansprüche 1 bis 3, wobei sich das wenigstens eine Wärmerohr (35) im Wesentlichen über die gesamte zur Verfügung stehende Breite (36) des Baugruppenträgers (2) erstreckt.

5. Kühlsystem (10) nach einem der Ansprüche 1 bis 4, wobei das wenigstens eine Wärmerohr (35) mit einer Vielzahl von Kühlkörpern (45) versehen ist.

6. Kühlsystem (10) nach Anspruch 5, wobei die Kühlkörper (45) derart ausgeführt sind, dass die von ihnen abgegebene Wärme von einer durch das Innenvolumen (14) des Baugruppenträgers (2) laufenden Konvektionsströmung abtransportierbar ist.

7. Elektronik-Aufbausystem (1) mit einem lüfterlosen Kühlsystem (10) nach einem der Ansprüche 1 bis 6 zur Kühlung einer in dem Baugruppenträger (2) aufgenommenen, eine Anzahl Mehrkernprozessoren (15) aufweisenden Prozessorbaugruppe (3) für eine fahrzeugseitige Rechnerplattform für eine Zugsicherungseinrichtung.

## Claims

1. Fanless cooling system (10) for electronic modular systems (1) for use in vehicles, in particular in rail vehicles,
- with a rack (2) for accommodating at least one module (3), in particular a processor module,
- with a heat transport body (18), which can be coupled to a part (15, 16) of the module (3) in a heat-transferring manner,
- wherein the rack (2) has at least one heat distribution body (26; 39), to which the heat transport body (18) can be fastened in a heat-transferring manner, when the module (3), to the part (15, 16) of which the heat transport body (18) is coupled, is accommodated in the rack (2),
- and with at least one heat pipe (35) connected to the heat distribution body (26, 39) in a heat-transferring manner,
**characterised in that**
the rack (2) has two side parts (5, 6), which stand perpendicular to a bottom side (11) and a top side (12) of the rack (2) and run in the rack transverse direction (4), and
the bottom side (11) and the top side (12) of the rack (2) are at least partially permeable to air.

2. Cooling system (10) according to claim 1, wherein the heat transport body (18) is designed as a housing which at least partially encloses a circuit board (17) of the module (3).

3. Cooling system (10) according to claim 1 or 2, with a wedge lock apparatus (27) for fastening the heat transport body (18) to the heat distribution body (26; 39) in a heat-transferring manner.

4. Cooling system (10) according to one of claims 1 to 3, wherein the at least one heat pipe (35) extends substantially over the entire available width (36) of the rack (2).

5. Cooling system (10) according to one of claims 1 to 4, wherein the at least one heat pipe (35) is provided with a large number of cooling bodies (45).

6. Cooling system (10) according to claim 5, wherein the cooling bodies (45) are designed such that the heat which they emit can be removed by a convection current running through the internal volume (14) of the rack (2).

7. Electronic modular system (1) with a fanless cooling system (10) according to one of claims 1 to 6 for the cooling of a processor module (3), which is accommodated in the rack (2) and has a number of multi-core processors (15), for a vehicle-side computer platform for a piece of train protection equipment.

## Revendications

1. Système (10) de refroidissement sans ventilateur de systèmes (1) de structure d'électronique à utiliser dans des véhicules, notamment dans des véhicules ferroviaires,
- comprenant un porte-module (2) de réception d'au moins un module (3), notamment d'un module de processeur,
- comprenant un corps (18) de propagation de la chaleur, qui peut être monté d'une manière à transmettre la chaleur sur une pièce (15, 16) du module (3),
- dans lequel le porte-module (2) a au moins un corps (26 ; 39) de répartition de la chaleur, sur lequel le corps (18) de propagation de la chaleur peut être fixé d'une manière à transmettre la chaleur, lorsque le module (3), sur la pièce (15, 16) duquel le corps (18) de propagation de la chaleur est monté, est reçu dans le porte-module (2),
- et comprenant au moins un caloduc (35) relié d'une manière à transmettre la chaleur au corps (26 ; 39) de répartition de la chaleur,
**caractérisé**
**en ce que** le porte-module (2) a deux parties (5, 6) latérales perpendiculaires à une face (11) inférieure et à une face (12) supérieure du porte-module (2) et s'étendant dans la direction (4) transversale du porte-module et
**en ce que** la face (11) inférieure et la face (12) supérieure du porte-module (2) sont perméables à l'air au moins en partie.

2. Système (10) de refroidissement suivant la revendication 1, dans lequel le corps (18) de propagation de la chaleur est réalisé sous la forme d'un boîtier enveloppant, au moins en partie, une plaquette (17) à circuit imprimé du module (3).

3. Système (10) de refroidissement suivant la revendication 1 ou 2, comprenant un agencement (27) de fermeture à coin pour fixer le corps (18) de propagation de la chaleur au corps (26 ; 39) de répartition de la chaleur, d'une manière à transmettre la chaleur.

4. Système (10) de refroidissement suivant l'une des revendications 1 à 3, dans lequel le au moins un caloduc (35) s'étend essentiellement sur toute la largeur (36) disponible du porte-module (2).

5. Système (10) de refroidissement suivant l'une des revendications 1 à 4, dans lequel le au moins un caloduc (35) est pourvu d'une pluralité de dissipateurs (45) de chaleur.

6. Système (10) de refroidissement suivant la revendication 5, dans lequel les dissipateurs (45) de chaleur sont réalisés de manière à pouvoir évacuer la chaleur qu'ils cèdent par un courant de convection passant dans le volume (14) intérieur du porte-module (2).

7. Système (1) de structure d'électronique, comprenant un système (10) de refroidissement sans ventilateur suivant l'une des revendications 1 à 6, pour le refroidissement d'un module (3) de processeur reçu dans le porte-module (2) et ayant un certain nombre de processeurs (15) à plusieurs noyaux, pour une plateforme informatique embarquée d'un dispositif de protection des trains.
